**Europäisches Patentamt**

**European Patent Office**

**Office européen des brevets**

(19)

(11) Numéro de publication: **0 178 969 B1**

(12) **FASCICULE DE BREVET EUROPEEN**

(45) Date de publication du fascicule du brevet:
13.07.88

(51) Int. Cl.⁴: **C 23 C 14/08, G 02 B 1/10**

(21) Numéro de dépôt: **85401784.5**

(22) Date de dépôt: **16.09.85**

(54) **Procédé de dépôt sur substrats optiques de couches antiréfléchissantes susceptibles d'être gravées.**

(30) Priorité: **19.09.84 FR 8414369**

(43) Date de publication de la demande:
**23.04.86 Bulletin 86/17**

(45) Mention de la délivrance du brevet:
**13.07.88 Bulletin 88/28**

(84) Etats contractants désignés:
**AT BE CH DE GB IT LI LU NL SE**

(56) Documents cités:
**DE - C - 835 203**
**FR - A - 1 449 361**
**FR - A - 2 138 946**
**FR - A - 2 375 343**
**US - A - 3 698 928**

**IBM TECHNICAL DISCLOSURE BULLETIN, vol. 13, no. 3, août 1970, page 752, New York, US; J.S. JUDGE et al.: "Antireflective chrome photomasks"**
**JOURNAL OF THE ELECTROCHEMICAL SOCIETY, vol. 121, no. 7, juillet 1974, pages 952-959; G.C. FRYBURG et al.: "Enhanced oxidative vaporization of Cr2O3 and chromium by oxygen atoms"**
**OPTICS AND LASER TECHNOLOGY, vol. 4, no. 2, avril 1972, pages 79-86; T.I. PUTNER: "The vacuum deposition of metal oxide films by automatic control"**

(73) Titulaire: **D.M.E., 16 rue de la Véga, F-75012 PARIS (FR)**

(72) Inventeur: **Letellier, Michel, 16 rue de la Véga, F-75012 Paris (FR)**

(74) Mandataire: **CABINET BONNET-THIRION, 95 Boulevard Beaumarchais, F-75003 Paris (FR)**

(56) Documents cités: (suite)
**CHEMICAL ABSTRACTS, vol. 97, no. 22, 29 novembre 1982, page 190, résumé no. 185390w, Columbus, Ohio, US; B. CHOU et al.: "Evaporated double-layer black chrome selective coatings"**

ACTORUM AG

**Description**

L'invention se rapporte à un procédé de dépôt, sur des substrats optiques, de couches antiréfléchissantes susceptibles de gravure chimique, par évaporation d'un métal en atmosphère réactive, dans l'enceinte d'un évaporateur sous vide.

Il est souvent nécessaire, dans des appareils d'optique, d'obtenir des réticules ou des trames opaques dans un champ où se forme une image, pour repérer un axe de visée, ou mesurer des angles paraxiaux, par exemple. La gravure directe, au diamant ou chimique, d'une pièce optique, lame de verre notamment, s'est trouvée limitée en précision et définition, l'opacité des traits, nécessaire pour obtenir un bon contraste impliquant le garnissage des traits par un pigment. On conçoit que cette technique ne permet pas des résolutions ultimes, qui approchent les longueurs d'ondes du spectre visible.

On a préconisé le dépôt de couches opaques par des techniques de dépôt sous vide, par évaporation ou pulvérisation cathodique, le motif de trame ou de réticule étant obtenu, soit par gravure chimique ultérieure à travers un masque ou réserve de microphotolithographie, soit en effectuant le dépôt sur un substrat recouvert d'un masque analogue aux masques de microphotolithographie.

Le document FR-A-2 117 849 décrit une technique de dépôt en phase vapeur, le dépôt se formant par réaction au contact du substrat chauffé d'un composé évaporé et d'un gaz réactif, dilué dans un gaz vecteur neutre à pression voisine de la pression atmosphérique. Selon ce document les couches préférées sont des oxydes métalliques, le gaz réactif contenant alors un peu d'oxygène ou d'un oxydant volatil. Les composés évaporables sont, entre autres des organométalliques, acétylacétonates par exemple, des métaux carbonyles, ou des oxychlorures.

On notera que selon ce document, pour obtenir des couches opaques, on procède à une réduction de l'oxyde déposé pour former une couche métallique réfléchissante en additionnant le gaz vecteur d'un gaz réducteur, comme l'hydrogène, l'oxyde de carbone, le méthane.

Il est clair que les réflexions de la lumière sur les trames ou réticules provoquent des pertes de résolution ou de contraste.

L'utilisation de couches d'épaisseur déterminée, en relation avec la longueur d'onde, permet d'éliminer, tout au moins d'atténuer les réflexions d'une couche métallique. Dans la pratique si le dépôt d'une couche d'oxyde d'épaisseur contrôlée au-dessus du dépôt métallique permet d'obtenir des réflectances inférieures à 2% de la réflectance spéculaire du côté opposé au substrat, la réflectance à l'interface substrat dépôt reste relativement élevée.

Les processus de dépôt suivant le document précité sont relativement lents (de l'ordre de la dizaine de minute pour une seule couche) et consomment des quantités relativement importantes de réactifs et de gaz vecteurs.

On a tenté d'obtenir des couches d'oxydes métalliques par évaporation du métal de base en atmosphère oxydante, à des pressions inférieures à la centaine de millipascals.

L'oxyde de titane semblait prometteur de ce point de vue. Mais les solutions de gravure chimique efficaces pour l'oxyde de titane présentent une agressivité notable vis-à-vis de la silice, constituant des substrats de verre.

Suivant l'invention, a été mis au point un procédé de dépôt, sur des substrats optiques, de couches antiréfléchissantes susceptibles, de gravure chimique, par évaporation de chrome en atmosphère d'oxygène pur, dans l'enceinte d'un évaporateur sous vide, caractérisé en ce que l'on dispose dans l'enceinte les substrats préalablement nettoyés, on évacue l'enceinte jusqu'à obtenir une pression d'au plus 1,5 μPa, on injecte l'oxygène pur dans l'enceinte à un débit réglé en sorte que la pression soit comprise entre 2 et 4 mPa, on démasque une nacelle chauffée disposée dans l'enceinte et contenant du chrome à une température telle qu'une couche d'oxyde de chrome croisse en épaisseur sur les substrats de 0,1 à 0,5 nm par seconde, et on masque la nacelle lorsque la couche d'oxyde de chrome a atteint une épaisseur correspondant à la première extinction en réflexion spéculaire sous incidence sensiblement normale.

Ce procédé permet d'obtenir des dépôts d'oxyde de chrome avec une densité optique de près de 2 et un facteur de réflexion de l'ordre de 1% à 550 nm et de l'ordre de 20 à 30% aux extrémités de la plage 400–700 nm (valeurs expérimentales).

On appréciera que la répétabilité des résultats du procédé a été assurée par la détermination de chacun des paramètres de dépôt, les influences de ces divers paramètres n'étant pas indépendantes.

On précise que la densité optique correspond aux rapports des intensités lumineuses incidente et transmise, une densité 2 représentant un rapport de $10^2$. Les facteurs de réflexion sont pris par rapport à la réflexion spéculaire.

De préférence, on contrôle la croissance en épaisseur de la couche déposée par mesure de la dérive de fréquence de résonance d'un résonateur à lame de quartz, une face de cette lame étant exposée au dépôt dans les mêmes conditions sensiblement que le substrat. Ce processus de contrôle est classique dans son principe. La masse d'oxyde de chrome déposée modifie la fréquence de résonance mécanique d'une lame de quartz.

De préférence également, on détermine l'instant où il faut masquer la nacelle contenant le chrome, pour arrêter la croissance de la couche d'oxyde déposée, par l'annulation pratique de la réflectance d'un substrat témoin soumis au dépôt et préalablement recouvert d'une couche métallique à réflexion spéculaire, c'est-à-dire lorsque cette réflectance est inférieure à 2% de la réflectance spéculaire. On rappelle que l'annulation de la réflectance se produit par interférence en opposition de phase des rayonnements réfléchis par les deux faces de la couche d'oxyde de chrome, et n'est, en toute rigueur complète que pour une seule fréquence. Juste avant de s'annuler, la lumière réfléchie d'une source blanche prend des teintes caractéristiques. L'annulation correspond à ce qui est connu comme passage à la teinte sensible.

Pour contrôler l'annulation de la réflectance, on opère de préférence avec une source de lumière blanche à température de couleur de 3400 K.

Si l'on souhaite dépasser la densité en transmission de 2, on exécutera un dépôt de chrome métallique sous vide poussé. Ce dépôt sera situé entre substrat et couche d'oxyde de chrome lorsque la réflectance doit être pratiquement nulle vue du côté du dépôt, et sur la couche d'oxyde de chrome si la réflectance doit être pratiquement nulle vue du côté du substrat, à travers celui-ci. Si l'on veut que la réflectance soit pratiquement nulle vue de l'un et l'autre côté, on exécutera le dépôt de chrome métallique sur une première couche d'oxyde de chrome, puis on déposera une seconde couche d'oxyde de chrome au-dessus du dépôt de chrome métallique.

Du côté de l'observation la couche d'oxyde de chrome annule pratiquement la réflectance du dépôt de chrome métallique, tandis que la densité en transmission de ce dépôt vient s'ajouter à la densité propre de l'oxyde de chrome.

On notera que l'on obtient ainsi aisément des densités d'au moins 4. Des facteurs de transmission inférieurs à $10^{-4}$ ne sont pratiquement plus mesurables.

Les caractéristiques et avantages de l'invention ressortiront d'ailleurs de la description qui va suivre et constituera exemple.

Le processus de dépôt s'effectue dans un appareil de dépôt sous vide tout-à-fait classique, tel qu'on le trouve commercialisé par différents constructeurs de matériel pour vide.

Pour fabriquer des réticules pour appareils d'optique de précision, on prend des substrats de verre de qualité optique, qui sont nettoyés chimiquement de façon classique, rincés à l'eau déminéralisée, et séchés par immersion dans l'acétone et étuvage à 70–80 °C.

Les substrats sont portés à l'emplacement des cibles sur la platine d'un appareil d'évaporation sous vide. Une nacelle équipée d'un moyen de chauffage par effet Joule, et équipée d'un cache ou masque manœuvrable de l'extérieur, est garnie de chrome pur pulvérulent. Entre les substrats on dispose un résonateur à quartz, fourni par la société Leybold, et on branche ce résonateur sur ses circuits d'excitation et de mesure, en utilisant des passages isolés étanches de la platine. On dispose également un substrat dit témoin, préalablement revêtu d'un métallique à réflexion spéculaire. On ferme l'enceinte de l'évaporateur et on commence le pompage de l'enceinte, d'abord en vide primaire (prévidage), puis on ferme la vanne de prévidage et on ouvre la vanne de vide secondaire.

On procède alors à un étuvage, à une température appropriée aux substrats à recouvrir, et pendant une durée telle que la pression, après un palier qui correspond à l'évaporation de l'eau en surface des substrats, amorce une décroissance nette. On arrête alors l'étuvage, et on effectue un dégazage de la nacelle et de son contenu vers 700 °C avec un démasquage bref, jusqu'à ce que la pression dans l'enceinte, après une remontée temporaire, reprenne sa décroissance.

On surveille la pression dans l'enceinte, à l'aide des jauges qui équipent l'appareil d'évaporation. Lorsque la pression s'est abaissée à 1,5 μPa, on passe à la phase suivante. On notera que les jauges à vide sont fréquemment graduées en torrs; on considérera que le pompage à $10^{-8}$ torr est suffisant. On comprendra que, bien que $10^{-8}$ torr corresponde à 1,3 μPa, la précision des jauges n'est pas suffisante pour que l'écart de lecture entre 1,3 et 1,5 μPa soit significatif.

Pour la phase de dépôt proprement dite, on injecte de l'oxygène pur à travers une vanne micrométrique, dite vanne à aiguille, sans interrompre le pompage, en réglant le débit d'oxygène pour que la pression soit comprise entre 2 et 4 mPa, en visant 3 mPa ($2 \times 10^{-5}$ torr).

Bien entendu, lors des premières utilisations de l'appareillage, et lorsqu'on change la bouteille d'oxygène, on effectue des rinçages à l'oxygène au cours de la mise sous vide primaire.

Avec de l'oxygène à la pression de 2–4 mPa, on démasque la nacelle contenant le chrome, afin que ce métal s'évapore, et se dépose, à l'état combiné avec l'oxygène. La tension d'alimentation de l'élément chauffant de la nacelle qui contient le chrome est réglée pour que la vitesse de dépôt s'établisse à une valeur comprise entre 0,1 et 0,5 nm en visant 0,2 nm. Cette vitesse est contrôlée à l'aide du résonateur à quartz, qui reçoit sur sa face supérieure le même dépôt que les substrats.

On surveille la teinte prise par le témoin; lorsque le dépôt paraît jaune par réflexion, on mesure la réflexion en éclairant ce témoin avec une lumière blanche (lampe à halogène à 3400 K) et mesurant l'intensité réfléchie avec une photodiode étalonnée, visant le substrat témoin, à travers un filtre centré sur 550 nm. On arrête le dépôt en masquant la nacelle lorsque le facteur de réflexion, mesuré par la photodiode, est inférieur à 2% du facteur de réflexion spéculaire. En lumière blanche le dépôt apparaît noir intermédiaire entre le jaune et le cyan (en fait on ne laisse pas le dépôt s'accroître jusqu'à une teinte cyan). On ferme l'injection d'oxygène.

La durée du dépôt se situe, dans les coditions opératoires décrites, aux environs de 200 secondes. La tolérance de durée est d'environ 10 secondes.

Après une période de refroidissement, le vide est supprimé dans l'enceinte, et les substrats prêts pour la gravure.

Le contrôle optique des substrats recouverts à ce stade montre que, en transmission le dépôt présente une densité optique de 2. En réflexion, à 550 nm le facteur de réflexion est d'envrion 1%, pour s'élever à 20 à 30% aux extrémités du spectre visible (400 et 700 nm).

Lorsque l'on veut obtenir une densité d'opacité en transmission supérieure à 2 on exécute un dépôt de chrome métallique. Pour le dépôt de chrome métallique on opère sous vide élevé, de l'ordre de 1,5 μPa, et l'on démasque la nacelle pendant une durée convenable, correspondant à la densité d'opacité requise. Si le dépôt de chrome métallique est effectué directement sur le substrat, on déterminera l'opacité de ce dépôt en tenant compte de ce que le dépôt d'oxyde présentera de soi une densité de 2. Avec le dépôt de chrome métallique sur le substrat, le revêtement du substrat sera réfléchissant vu à travers ce dernier, et non réfléchissant vu du côté du dépôt d'oxyde de chrome. Si l'on effectue le dépôt de chrome métallique sur la couche d'oxyde de chrome, en démasquant la nacelle à nouveau après que la couche d'oxyde de chrome ait été formée, et que l'oxygène ait été évacué après fermeture de la vanne aiguille, l'ensemble du dépôt apparaîtra comme réfléchissant du côté du dépôt, et non réfléchissant vu à travers le substrat.

Enfin, si l'on dépose une première couche d'oxyde de chrome, on exécute un dépôt de chrome métallique sur cette première couche d'oxyde de chrome, puis on dépose sur le chrome métallique une seconde couche d'oxyde de chrome dans les mêmes conditions que la première, le revêtement du substrat sera opaque et non réfléchissant vu de l'un et l'autre côtés.

Pour constituer un réticule, les substrats revêtus d'oxyde de chrome sont recouverts d'une résine photosensible, et insolés à travers un masque approprié; la résine insolée est dépouillée, puis le dépôt est gravé, tous ces processus étant classiques en microphotolithographie. Mais, grâce à l'épaisseur réduite du dépôt (environ 50 nm), il est possible de réaliser par gravure des traits extrêmement fins. Aussi, tous les processus aptes à conférer aux masques et à l'insolation une excellente résolution, voisine de la résolution de diffraction, viennent coopérer avec le procédé de l'invention pour l'exécution de réticules de très haute précision.

Mais bien entendu, tout le processus de gravure est en dehors du cadre de la présente invention.

## Revendications

1. Procédé de dépôt, sur des substrats optiques, de couches antiréfléchissantes susceptibles de gravure chimique par évaporation de chrome en atmosphère d'oxygène pur dans l'enceinte d'un évaporateur sous vide, caractérisé en ce que l'on dispose dans l'enceinte les substrats préalablement nettoyés, on évacue l'enceinte jusqu'à obtenir une pression d'au plus 1,5 μPa, on injecte l'oxygène pur dans l'enceinte à un débit réglé en sorte que la pression soit comprise entre 2 et 4 mPa, on démasque une nacelle chauffée disposée dans l'enceinte et contenant du chrome à une température telle qu'une couche d'oxyde de chrome croisse en épaisseur sur les substrats de 0,1 à 0,5 nm par seconde, et on masque la nacelle lorsque la couche d'oxyde de chrome a atteint une épaisseur correspondant à la première extinction en réflexion spéculaire sous incidence sensiblement normale.

2. Procédé suivant la revendication 1, caractérisé en ce que la température du chrome dans la nacelle est telle que la couche d'oxyde croisse en épaisseur de 0,2 nm par seconde.

3. Procédé suivant l'une des revendications 1 et 2, caractérisé en ce que l'on contrôle la croissance en épaisseur de la couche d'oxyde de chrome par mesure de la dérive de fréquence de résonance d'un résonateur à quartz exposé au dépôt sensiblement dans les mêmes conditions que les substrats.

4. Procédé suivant une quelconque des revendications 1 à 3, caractérisé en ce que l'on détermine la réflectance d'un substrat témoin dont la face exposée au dépôt a préalablement reçu une couche métallique à réflexion spéculaire, et on masque la nacelle lorsque la réflectance du substrat témoin est inférieure à 2% de la réflectance spéculaire à une longueur d'onde choisie.

5. Procédé suivant la revendication 4, caractérisé en ce que la réflectance du substrat témoin est déterminée en utilisant une source de lumière blanche à température de couleur 3400 K.

6. Procédé suivant une quelconque des revendications 1 à 5, donnant des couches à grande opacité destinées à l'observation d'un seul côté, soit du côté du dépôt, soit du côté du substrat, caractérisé en ce que l'on exécute un dépôt de chrome métallique en vide poussé, respectivement avant ou après le dépôt d'oxyde de chrome.

7. Procédé suivant une quelconque des revendications 1 à 5, donnant des couches à grande opacité destinées à l'observation des deux côtés du substrat, caractérisé en ce que l'on exécute un dépôt de chrome métallique sous vide poussé sur une première couche d'oxyde de chrome, puis une seconde couche d'oxyde de chrome au-dessus du dépôt de chrome métallique.

8. Procédé suivant l'une des revendications 6 et 7, caractérisé en ce qu'on règle l'épaisseur du dépôt de chrome métallique avec une densité en transmission qui complète la densité propre de la couche d'oxyde de chrome, pour obtenir la densité voulue.

## Patentansprüche

1. Verfahren zum Überziehen von optischen Substraten mit reflexionsmindernden Schichten, die geätzt werden können, durch Verdampfen von Chrom in einer reinen Sauerstoffatmosphäre in einem Vakuumrezipienten, dadurch gekennzeichnet, dass die gereinigten Substrate in den Rezipienten eingebracht werden, dass der Rezipient bis auf ein Vakuum über 1,5 μPa evakuiert wird, dass in den Kessel reiner Sauerstoff eingelassen wird in einer Menge, die derart eingestellt ist, dass der Druck zwischen 2 und 4 mPa beträgt, dass die Abdeckung einer in dem Rezipienten angeordneten beheizten Quelle geöffnet wird, die Chrom enthält, das eine derartige Temperatur hat, dass auf den Substraten eine Chromoxidschicht mit einer Dickenwachstumsrate von 0,1 bis 0,5 nm.s abgeschieden wird, und dass die Abdeckung der Quelle geschlossen wird, wenn die Chromoxidschicht eine Dicke erreicht hat, die der ersten Auslöschung der Spiegelreflexion bei im wesentlichen senkrechtem Lichtausfall entspricht.

2. Verfahren nach Anspruch 1, dadurch gekennzeichnet, dass die Temperatur des Chroms in der Quelle derart gewählt wird, dass die Oxidschicht ein Dickenwachstum von 0,2 nm/s hat.

3. Verfahren nach einem der Ansprüche 1 oder 2, dadurch gekennzeichnet, dass das Dickenwachstum der Chromoxidschicht durch Messung der Abweichung von der Resonanzfrequenz eines Quartzschwingers gemessen wird, der im wesentlichen unter den gleichen Bedingungen beschichtet wird wie die Substrate.

4. Verfahren nach einem der Ansprüche 1 bis 3, dadurch gekennzeichnet, dass die Reflektivität eines Vergleichssubstrates bestimmt wird, deren der Beschichtung ausgesetzte Oberfläche vorher mit einer spiegelnd reflektierenden Metallschicht versehen ist, und dass die Abdeckung der Quelle geschlossen wird, wenn die Reflektivität des Vergleichssubstrates unterhalb von 2% der Spiegelreflektivität bei einer ausgewählten Wellenlänge liegt.

5. Verfahren nach Anspruch 4, dadurch gekennzeichnet, dass die Reflektivität des Vergleichssubstrats unter Verwendung einer weissen Lichtquelle mit einer Farbtemperatur von 3400 K bestimmt wird.

6. Verfahren nach einem der Ansprüche 1 bis 5, bei dem Schichten mit grosser Opazität vorgesehen sind, die für die Betrachtung einer Seite bestimmt sind, sei es von der Seite des Niederschlages, sei es von der Seite des Substrates, dadurch gekennzeichnet, dass eine metallische Chromschicht im Vakuum abgeschieden wird, und zwar vor oder nach der Abscheidung des Chromoxides auf dem Substrat.

7. Verfahren nach einem der Ansprüche 1 bis 5, bei dem Schichten grosser Opazität vorgesehen sind, die für die Betrachtung der beiden Seiten des Substrates bestimmt sind, dadurch gekennzeichnet, dass eine Schicht von metallischem Chrom im Vakuum abgeschieden wird, die auf eine erste Chromoxidschicht aufgebracht wird und dass auf die metallische Chromschicht eine zweite Chromoxidschicht aufgebracht wird.

8. Verfahren nach einem der Ansprüche 6 und 7, dadurch gekennzeichnet, dass die Dicke der Schicht aus metallischem Chrom so bestimmt wird, dass eine Transmissionsdichte erzielt wird, die die Transmissionsdichte der Chromoxidschicht auf die gewünschte Enddichte ergänzt.

**Claims**

1. Method for coating optical substrates with anti-reflective layers which can be chemically etched by evaporation of chromium in an atmosphere of pure oxygen in the chamber of an evaporator under vacuum, characterised in that the substrates, which have been previously cleaned, are placed in the chamber, the chamber is evacuated intil a pressure of at most 1.5 µPa is obtained, the pure oxygen is injected into the chamber at a regulated flow so that the pressure is between 2 and 4 mPa, a heated boat arranged in the chamber is uncovered, said boat containing chromium at a temperature such that a layer of chromium oxide increases in thickness on the substrates from 0.1 to 0.5 nm per second, and the boat is covered when the chromium oxide layer has reached a thickness corresponding to the first extinction in specular reflection at substantially normal incidence.

2. Method according to claim 1, characterised in that the temperature of the chromium in the boat is such that the layer of oxide increases in thickness by 0.2 nm per second.

3. Method according to one of claims 1 and 2, characterised in that the increase in thickness of the chromium oxide layer is checked by measuring the deviation in resonance frequency of a quartz resonator exposed to the coating substantially in the same conditions as the substrates.

4. Method according to any one of claims 1 to 3, characterised in that the reflectance of a reference substrate, whose surface exposed to the coating has previously received a metal layer with specular reflection, is determined, and the boat is covered when the reflectance of the reference substrate is lower than 2% of the specular reflectance at a selected wavelength.

5. Method according to claim 4, characterised in that the reflectance of the reference substrate is determined by using a source of white light at a colour temperature of 3400 K.

6. Method according to any of claims 1 to 5, giving layers of great opacity for the purpose of observing from one side only, either from the side of the coating or from the side of the substrate, characterised in that a coating of metal chromium is laid at high vacuum, respectively before ar after the chromium oxide has been deposited.

7. Method according to any one of claims 1 to 5, giving layers of great opacity for the purpose of observing from both sides of the substrate, characterised in that a coating of metal chromium is laid at high vacuum on a first layer of chromium oxide, then a second layer of chromium oxide on top of the coating of metal chromium.

8. Method according to one of claims 6 and 7, characterised in that the thickness of the metal chromium layer is regulated with a transmission density which completes the actual density of the chromium oxide layer, in order to obtain the desired density.